# EUROPÄISCHE PATENTANMELDUNG

(11) **EP 4 461 626 A1**
(43) Veröffentlichungstag der Anmeldung: **13.11.2024**
(21) Anmeldenummer: 24172848.4
(22) Anmeldetag: 26.04.2024
(51) Int. Cl.: B62D 29/04, B62D 31/00

(54) **REISEMOBILKAROSSERIEVORRICHTUNG**

(30) Priorität: 27.04.2023 DE 102023110992
(71) Anmelder: Scolotech GmbH, 88709 Meersburg (DE)
(72) Erfinder: Schuler, Karl-Heinz, 88255 Köpfingen über Baienfurt (DE)
(74) Vertreter: Daub, Thomas

(57) **Zusammenfassung**

Die Erfindung geht aus von einer Reisemobilkarosserievorrichtung, mit zumindest zwei Seitenwandmodulen (12, 14), einem Dachmodul (16) und einem Heckmodul (18), die zusammen zumindest einen Teil eines Karosserieaufbaus eines Reisemobils ausbilden, wobei das Heckmodul (18) eine rückwärtige Wandung des Karosserieaufbaus ausbildet.

Es wird vorgeschlagen, dass das Heckmodul (18) zumindest ein flächiges Sandwichelement (20), das einen Großteil des Heckmoduls (18) ausbildet, und zumindest zwei Seitenelemente (32, 34) aufweist, die jeweils an einem der Seitenwandmodule (12, 14) angebunden sind und jeweils einen Seitenbereich des Heckmoduls (18) ausbilden..

## Beschreibung

### Stand der Technik

Die Erfindung betrifft eine Reisemobilkarosserievorrichtung.

Es ist bereits eine Reisemobilkarosserievorrichtung, mit zumindest zwei Seitenwandmodulen, einem Dachmodul und einem Heckmodul, die zusammen zumindest einen Teil eines Karosserieaufbaus eines Reisemobils ausbilden, wobei das Heckmodul eine rückwärtige Wandung des Karosserieaufbaus ausbildet, vorgeschlagen worden.

Die Aufgabe der Erfindung besteht insbesondere darin, eine gattungsgemäße Vorrichtung mit verbesserten Eigenschaften hinsichtlich eines Gewichts und einer Gestaltungsmöglichkeit bereitzustellen. Die Aufgabe wird erfindungsgemäß durch die Merkmale des Patentanspruchs 1 gelöst, während vorteilhafte Ausgestaltungen und Weiterbildungen der Erfindung den Unteransprüchen entnommen werden können.

### Vorteile der Erfindung

Die Erfindung geht aus von einer Reisemobilkarosserievorrichtung, mit zumindest zwei Seitenwandmodulen, einem Dachmodul und einem Heckmodul, die zusammen zumindest einen Teil eines Karosserieaufbaus eines Reisemobils ausbilden, wobei das Heckmodul eine rückwärtige Wandung des Karosserieaufbaus ausbildet.

Es wird vorgeschlagen, dass das Heckmodul zumindest ein flächiges Sandwichelement, das einen Großteil des Heckmoduls ausbildet, und zumindest zwei Seitenelemente aufweist, die jeweils an einem der Seitenwandmodule angebunden sind und jeweils einen Seitenbereich des Heckmoduls ausbilden. Unter einer "Reisemobilkarosserievorrichtung" soll vorzugsweise eine Vorrichtung verstanden werden, die zumindest einen Teil eines Karosserieaufbaus, vorzugsweise einen gesamten Karosserieaufbau eines Reisemobils ausbildet. Der Karosserieaufbau bildet vorzugsweise einen Aufbau des Reisemobils, insbesondere Seitenwände, eine Rückwand, eine Frontwand und ein Dach des Reisemobils aus, die einen Innenraum des Reisemobils begrenzen. Unter einem "Seitenwandmodul" soll vorzugsweise ein Modul verstanden werden, das eine Seitenwand des Reisemobils ausbildet und sich vorzugsweise von einer Front bis an ein Heck des Reisemobils erstreckt. Unter einem "Dachmodul" soll vorzugsweise ein Modul verstanden werden, das ein Dach des Reisemobils ausbildet und sich vorzugsweise von einer Front bis an ein Heck des Reisemobils erstreckt. Das Dachmodul bildet vorzugsweise einen oberen Abschluss des Karosserieaufbaus, also des Reisemobils aus. Unter einem "Heckmodul" soll vorzugsweise ein Modul verstanden werden, das ein Heck des Reisemobils ausbildet und sich vorzugsweise zwischen den Seitenwandmodulen von einem Grundboden bis an das Dachmodul des Reisemobils erstreckt. Das Heckmodul bildet vorzugsweise einen hinteren Abschluss des Karosserieaufbaus, also des Reisemobils aus. Das Heckmodul bildet eine Rückwandung des Reisemobils aus. Die Module bestehen vorzugsweise aus einer Vielzahl von miteinander verbundenen Elementen. Unter einem "Seitenelement" soll vorzugsweise ein Element verstanden werden, das einen seitlichen Bereich, also einen einem Seitenwandmodul zugewandten Bereich des Heckmoduls ausbildet. Das Seitenelement bildet vorzugsweise ein Montagestruktur aus, an der weitere Elemente fest montierbar sind.

Unter einem "Sandwichelement" soll vorzugsweise ein flächiges Leichtbauelement verstanden werden, das zumindest zwei beabstandet angeordnete Decklagen, insbesondere einer Außenschicht und einer Innenschicht, und einen zwischen den beiden Decklagen angeordneten Kern aufweist. Der Kern ist vorzugsweise aus einem Schaumkern und/oder einem Wabenkern gebildet. Der Schaumkern kann dabei beispielsweise aus einem PU-Schaum gebildet sein. Grundsätzlich ist es auch denkbar, dass der Kern aus einem XPS-Schaum gebildet ist. Unter einem "Großteil des Heckmoduls" soll vorzugsweise mehr als 60%, bevorzugt zumindest 75% des Heckmoduls verstanden werden. Unter "vorgesehen" soll insbesondere speziell ausgelegt und/oder ausgestattet verstanden werden. Darunter, dass ein Objekt zu einer bestimmten Funktion vorgesehen ist, soll insbesondere verstanden werden, dass das Objekt diese bestimmte Funktion in zumindest einem Anwendungs- und/oder Betriebszustand erfüllt und/oder ausführt. Durch eine erfindungsgemäße Ausgestaltung kann ein besonders vorteilhafter Aufbau eines Heckmoduls erreicht werden, das vorteilhaft leicht ist und vorteilhaft flexible Möglichkeiten einer Gestaltung aufweist.

Weiter wird vorgeschlagen, dass die Seitenelemente jeweils aus einem Hartschaum-Grundkörper und einem mit dem Hartschaum-Grundkörper verbundenen Kunststoffelement gebildet sind. Unter einem "Hartschaum-Grundkörper" soll vorzugsweise ein Grundkörper verstanden werden, der aus einem Hartschaum gebildet ist, der dazu vorgesehen ist, dass Verbindungselemente damit verbunden werden können. Der Hartschaum-Grundkörper ist vorzugsweise als eine tragende Struktur ausgebildet, und dazu vorgesehen, Kräfte zu übertragen. Der Hartschaum-Grundkörper ist vorzugsweise aus einem EPP, also einem expandierten Polypropylen gebildet. Grundsätzlich kann der Hartschaum-Grundkörper auch aus einem anderen, Hartschaummaterial gebildet sein, beispielsweise aus einem XPS-Schaum, also einem extrudierten Polystyrol-Hartschaum, oder einem EPS, also einem expandierten Polystyrol-Hartschaum. Unter einem "Kunststoffelement" soll ein flächiges Element aus einem Kunststoff verstanden werden. Das Kunststoffelement ist vorzugsweise als ein plattenartiges Element mit einer Kontur ausgebildet. Das Kunststoffelement bildet vorzugsweise eine Kontur, insbesondere eine Außenkontur des Seitenelements aus. Das Kunststoffelement ist vorzugsweise von einem Tiefziehbauteil gebildet. Das Kunststoffelement ist vorzugsweise aus einem Thermoplast gebildet, der in einem Tiefziehverfahren in seine Form gebracht ist. Dadurch können die Seitenelemente besonders vorteilhaft stabil ausgebildet werden, wobei sie besonders vorteilhaft einfach zur Ausbildung einer geformten Außenkontur des Heckmoduls ausgeformt werden können.

Ferner wird vorgeschlagen, dass die Seitenelemente als Montage- und Verbindungselemente ausgebildet sind, die dazu vorgesehen sind, mit ihrem Hartschaum-Grundkörper jeweils direkt mit dem zugeordneten Seitenwandmodul verbunden zu werden. Darunter, dass das Seitenelement als ein "Montage- und Verbindungselement" ausgebildet ist, soll vorzugsweise verstanden werden, dass das Seitenelement dazu vorgesehen ist, dass weitere Elemente daran montierbar sind und dass das Seitenelement zur festen Verbindung mit weiteren Bauteilen, insbesondere weiteren Modulen der Reisemobilkarosserievorrichtung vorgesehen ist. Vorzugsweise sind Verbindungselemente, wie beispielsweise Schrauben, zur Anbindung des Seitenelements oder zur Montage von Elementen an dem Seitenelement direkt mit dem Hartschaum, oder mit in den Hartschaum integrierten Montageelementen verbindbar. Vorzugsweise bildet der Hartschaum-Grundkörper selbst eine Montagestruktur aus. Grundsätzlich ist es auch denkbar, dass Montagelemente, wie beispielsweise eine Montageplatte in den Hartschaumgrundkörper integriert sind oder auf dem Hartschaum-Grundkörper angebracht sind. Dadurch kann das Heckmodul besonders einfach an den Seitenwandmodulen angebunden werden.

Es wird weiterhin vorgeschlagen, dass das Heckmodul ein Stoßstangenelement aufweist, das lediglich an den Seitenelementen befestigt ist. Unter einem "Stoßstangenelement" soll vorzugsweise ein Element verstanden werden, das sich an einem unteren Ende des Heckmoduls quer zwischen den beiden Seitenwandmodulen erstreckt und einen unteren Abschluss des Heckmoduls ausbildet. Das Stoßstangenelement ist lediglich an seinen äußeren Enden jeweils mit dem entsprechenden Seitenelement fest verbunden. Das Stoßstangenelement ist mit dem Sandwichelement des Heckmoduls nicht direkt verbunden. Dadurch kann ein Stoßstangenelement besonders einfach in dem Heckmodul integriert werden.

Des Weiteren wird vorgeschlagen, dass das Kunststoffelement dazu vorgesehen ist, formschlüssig und/oder stoffschlüssig an dem Hartschaum-Grundkörper befestigt zu werden. Vorzugsweise ist das Kunststoffelement durch eine oder mehrere Klebeverbindungen stoffschlüssig mit dem Hartschaum-Grundkörper verbunden. Vorzugsweise ist das Kunststoffelement lediglich in Teilbereichen über Klebeverbindungen stoffschlüssig mit dem Hartschaum-Grundkörper verbunden. Vorzugsweise kann das flächige Kunststoffelement über ein oder mehrere Formschlusselemente allein oder zusätzlich zu einer Klebeverbindung fest mit dem Hartschaum-Grundkörper verbunden sein. Eine formschlüssige Verbindung zwischen dem Kunststoffelement und dem Hartschaum-Grundkörper kann vorzugsweise durch einen Hinterschnitt erfolgen, in dem das Kunststoffelement den Hartschaum-Grundkörper umgreift. Dadurch kann das Kunststoffelement besonders einfach mit dem Hartschaumgrundkörper verbunden werden und ein besonders stabiles Seitenelement bereitgestellt werden.

Weiterhin wird vorgeschlagen, dass der Hartschaum-Grundkörper, vorzugsweise auf seiner Rückseite, zumindest einen Befestigungskanal aufweist, wobei ein Klebeelement zur Verbindung des Kunststoffelements mit dem Hartschaum-Grundkörper dazu vorgesehen ist, in dem Befestigungskanal angeordnet zu werden. Unter einer "Rückseite" des Hartschaum-Grundkörpers soll vorzugsweise eine nach hinten ausgerichtete, in einem montierten Zustand von einem Innenraum der Reisemobilkarosserievorrichtung abgewandte, Seite verstanden werden. Unter einem "Befestigungskanal" soll vorzugsweise eine in den Hartschaumgrundkörper eingebrachte Nut verstanden werden, die dazu vorgesehen ist, dass ein Klebeelement, wie beispielsweise eine Kleberaupe zur Anbindung des Kunststoffelements darin angeordnet werden kann. Der Befestigungskanal verläuft in Verbindungsbereichen, in denen das Kunststoffelement mit dem Hartschaumgrundkörper verbunden ist. Vorzugsweise ist es denkbar, dass der Befestigungskanal in einem Randbereich des Hartschaum-Grundkörpers vorzugsweise umlaufend verläuft. Grundsätzlich ist es auch denkbar, dass der Hartschaum-Grundkörper mehrere kleinere voneinander getrennte Befestigungskanäle ausbildet. Unter einem "Klebeelement" soll ein Element verstanden werden, das zu einer Klebeverbindung von zwei Elementen vorgesehen ist, wobei das Klebeelement als eine Kleberaupe aus einem Klebstoff, oder als ein beidseitig haftender Klebestreifen ausgebildet sein kann. Dadurch können das Kunststoffelement und der Hartschaum-Grundkörper besonders vorteilhaft miteinander verbunden werden.

Außerdem wird vorgeschlagen, dass der Hartschaum-Grundkörper des jeweiligen Seitenelements und das Sandwichelement zumindest teilweise überlappend ausgebildet sind. Unter "teilweise überlappend" soll vorzugsweise verstanden werden, dass zwei Elemente, wie insbesondere der Hartschaum-Grundkörper und das Sandwichelement in zumindest einer Ebene überlappend angeordnet sind, also sich in zumindest einem Bereich nebeneinander erstrecken. Dadurch können das Sandwichelement und die Seitenelemente besonders vorteilhaft miteinander verbunden werden.

Der Hartschaum-Grundkörper des jeweiligen Seitenelements und das Sandwichelement sind vorzugsweise formschlüssig miteinander verbunden. Vorzugseise ist der Hartschaum-Grundkörper des jeweiligen Seitenelements und das Sandwichelement alternativ oder zusätzlich durch eine Klebeverbindung stoffschlüssig miteinander verbunden.

Es wird weiter vorgeschlagen, dass der Hartschaum-Grundkörper des jeweiligen Seitenelements und das Sandwichelement formschlüssig und durch eine Klebeverbindung stoffschlüssig miteinander verbunden sind. Dadurch kann das Sandwichelement besonders stabil mit dem Seitenelement verbunden werden.

Zudem wird vorgeschlagen, dass das Kunststoffelement in montiertem Zustand dazu vorgesehen ist, sich bis in einen Bereich des Sandwichelements zu erstrecken und eine Verbindungsfuge zwischen dem Hartschaum-Grundkörper und dem Sandwichelement zu überdecken. Dadurch kann ein Übergang zwischen dem Sandwichelement und dem Seitenelement besonders vorteilhaft ausgebildet werden.

Weiter wird vorgeschlagen, dass der Hartschaum-Grundkörper des jeweiligen Seitenelements und das Sandwichelement dazu vorgesehen sind, über mehrere Schraubenverbindungen fest miteinander verbunden zu werden. Dadurch kann das Seitenelement besonders einfach und stabil mit dem Sandwichelement verbunden werden.

### Zeichnungen

Weitere Vorteile ergeben sich aus der folgenden Zeichnungsbeschreibung. In den Zeichnungen ist ein Ausführungsbeispiel der Erfindung dargestellt. Die Zeichnungen, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: eine schematische Rückansicht der erfindungsgemäßen Reisemobilkarosserievorrichtung mit einem Heckmodul und zwei Seitenwandmodulen,
- Fig. 2: eine weitere schematische Rückansicht der Reisemobilkarosserievorrichtung mit dem Heckmodul, das ein Sandwichelement und zwei Seitenelemente aufweist,
- Fig. 3: eine schematische Schnittansicht C- C durch ein Seitenelement mit einem Hartschaum-Grundkörper und einem Kunststoffelement in einem oberen Spoilerbereich,
- Fig. 4: eine schematische Schnittansicht D - D durch das Sandwichelement in einem oberen Spoilerbereich,
- Fig. 5: eine schematische Schnittansicht E - E durch das Sandwichelement und einem Stoßstangenelement,
- Fig. 6: eine schematische Rückansicht auf einen unteren Bereich des Heckmoduls ohne das Stoßstangenelement,
- Fig. 7: eine schematische Schnittansicht F - F durch ein Seitenelement und das Stoßstangenelement und eine
- Fig. 8: eine schematische Schnittansicht J - J durch ein Seitenelement und ein Teil des Sandwichelements des Heckmoduls, und
- Fig. 9: eine schematische Schnittansicht durch eine Verbindung zwischen einem Seitenelement und dem Sandwichelement.

### Beschreibung des Ausführungsbeispiels

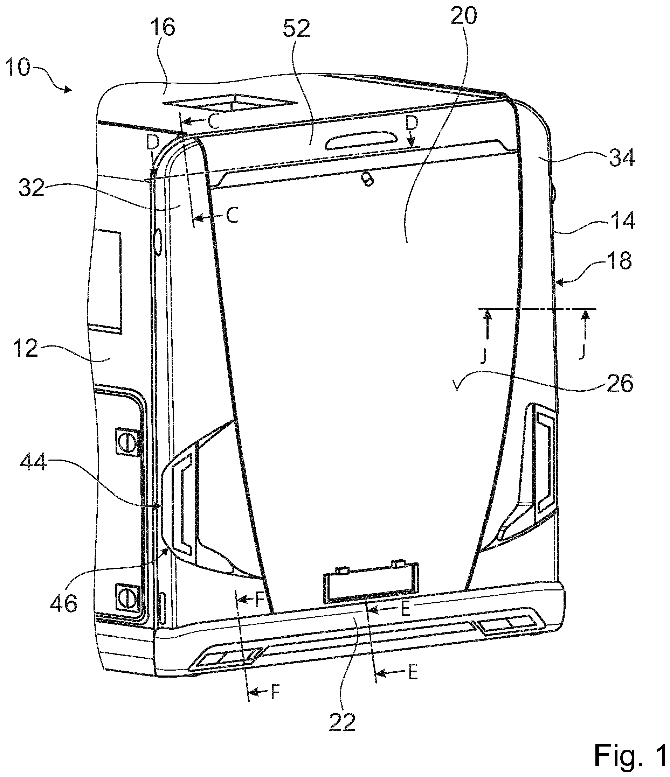

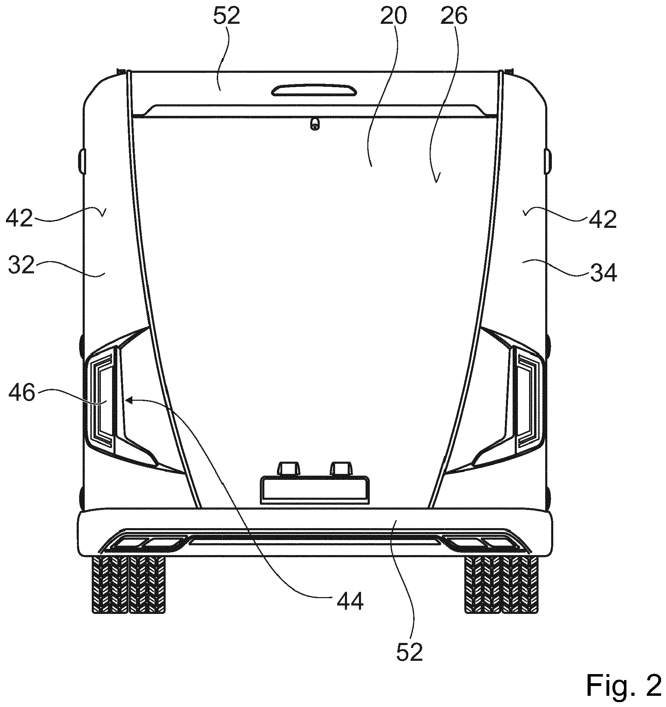

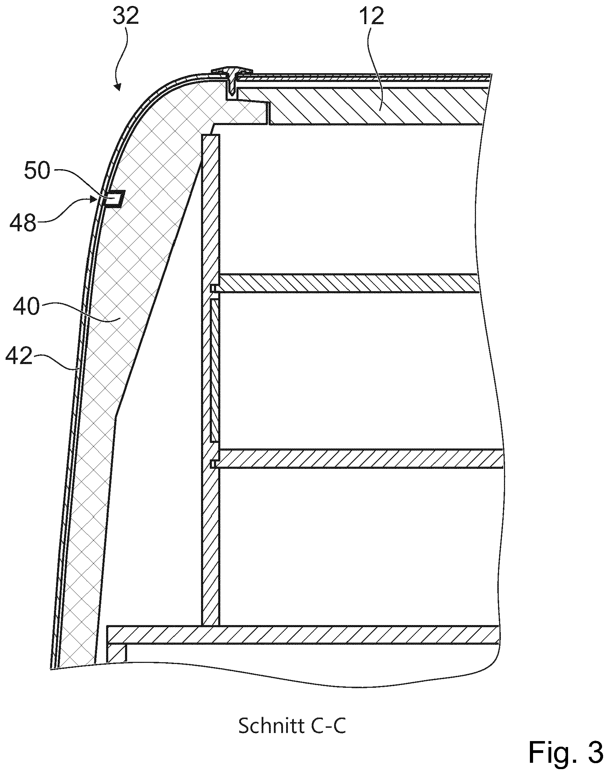

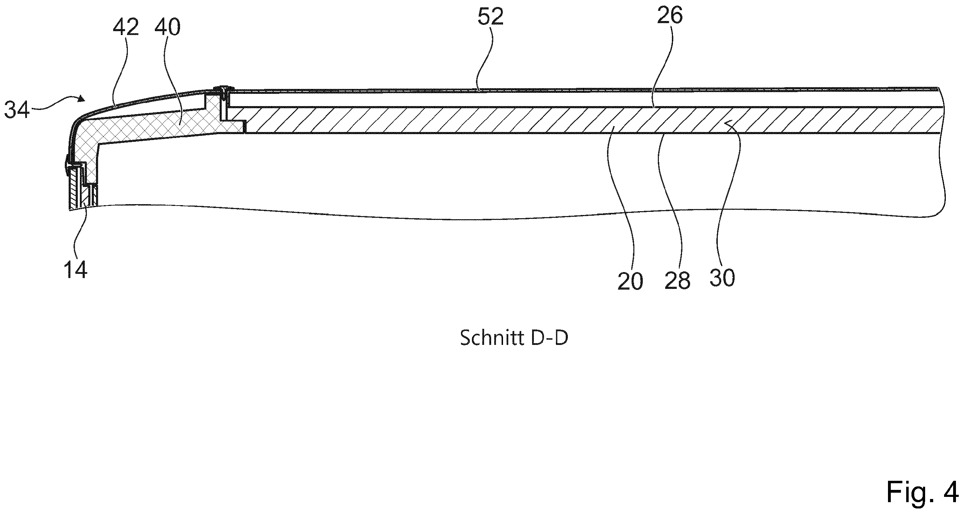

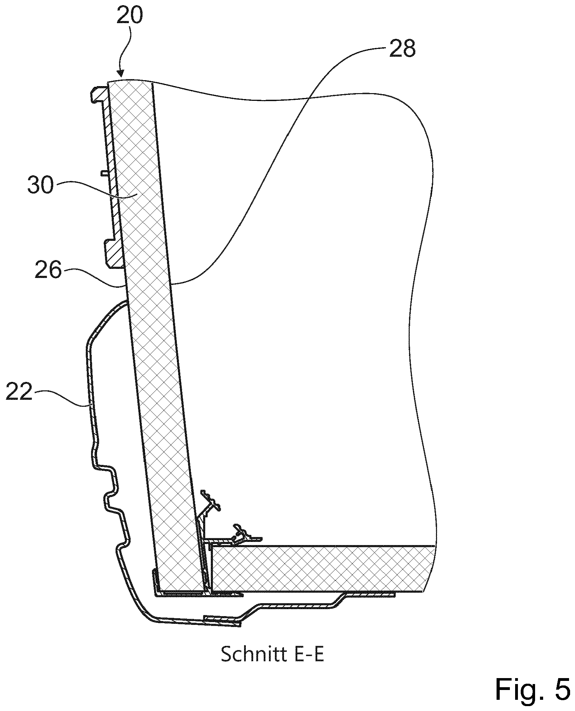

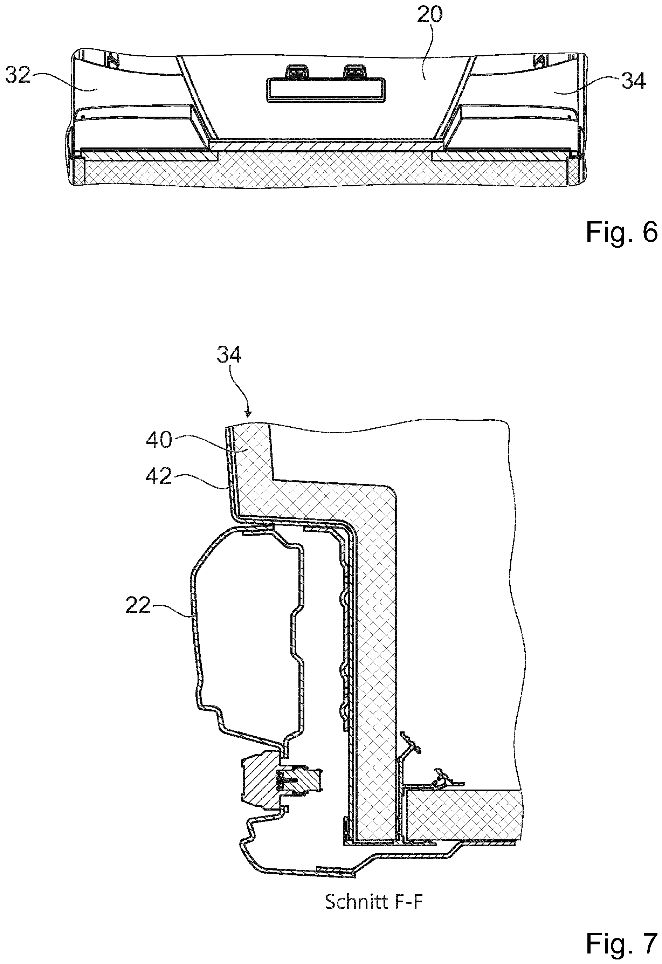

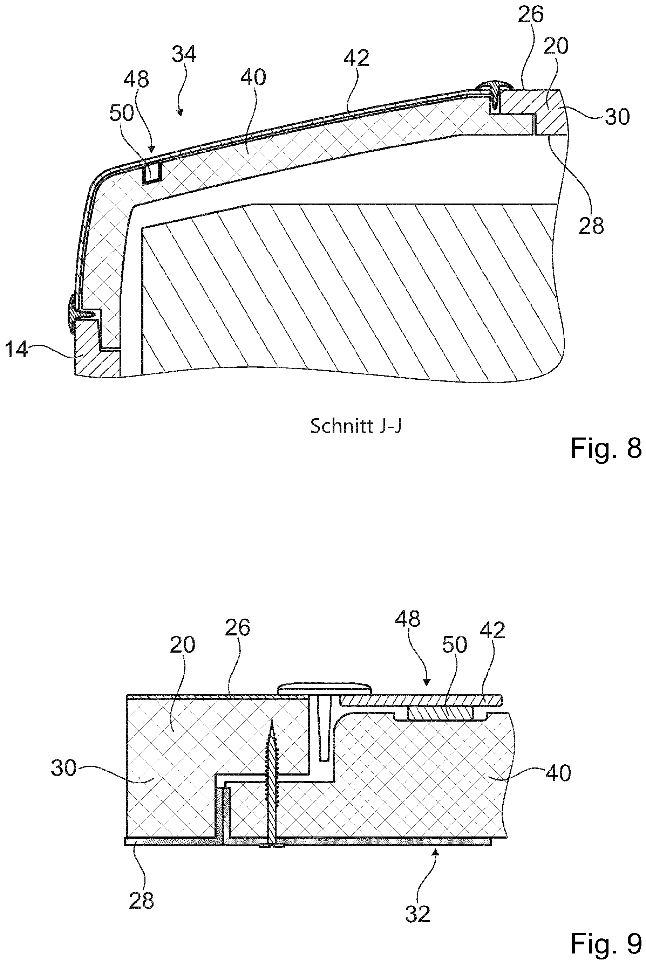

Die Figuren 1 bis 9 zeigen eine erfindungsgemäße Reisemobilkarosserievorrichtung 10. Die Reisemobilkarosserievorrichtung 10 ist als Teil eines in Figur 1 teilweise dargestellten Reisemobils ausgebildet. Das Reisemobil ist als ein Wohnmobil, insbesondere als ein vollintegriertes Wohnmobil, ausgebildet. Die Reisemobilkarosserievorrichtung 10 bildet einen Karosserieaufbau des Reisemobils aus. Die Reisemobilkarosserievorrichtung 10 begrenzt einen Innenraum des Reisemobils. Die Reisemobilkarosserievorrichtung 10 weist zwei Seitenwandmodule 12, 14 auf. Die Seitenwandmodule 12, 14 bilden jeweils eine Seitenwand des Reisemobils im Wesentlichen aus. Die Seitenwandmodule 12, 14 erstrecken sich vorzugsweise von einem Frontbereich des Reisemobils bis an ein Heck des Reisemobils. Die Reisemobilkarosserievorrichtung 10 weist ein Dachmodul 16 auf. Das Dachmodul 16 bildet ein Dach des Reisemobils aus. Das Dachmodul 16 ist an Oberseiten der Seitenwandmodule 12, 14 angeordnet.

Die Reisemobilkarosserievorrichtung 10 weist ein Heckmodul 18 auf. Das Heckmodul 18 ist an einem hinteren Ende der Seitenwandmodule 12,14 und dem Dachmodul 16 angeordnet. Das Heckmodul 18 bildet einen hinteren Abschluss der Reisemobilkarosserievorrichtung 10 aus. Das Heckmodul 18 schließt die Reisemobilkarosserievorrichtung 10 nach hinten ab. Das Heckmodul 18 bildet eine Rückwandung des Reisemobils aus. Das Heckmodul 18 schließt das Reisemobil nach hinten ab. Das Heckmodul 18 begrenzt den Innenraum des Reisemobils nach hinten. Das Heckmodul 18 bildet eine geschlossene Rückwandung des Reisemobils aus. Grundsätzlich wäre es auch denkbar, dass in das Heckmodul 18 Fenster und/oder Klappen integriert sind. Das Heckmodul 18 ist fest mit den Seitenwandmodulen 12, 14 gekoppelt. Das Heckmodul 18 ist fest mit dem Dachmodul 16 gekoppelt. Das Heckmodul 18 ist vorzugsweise starr mit den Seitenwandmodulen 12, 14 und dem Dachmodul 16 verbunden. Das Heckmodul 18 ist vorzugsweise jeweils direkt mit den Seitenwandmodulen 12, 14 und dem Dachmodul 16 verbunden. Das Heckmodul 18 bildet eine rechteckige Rückwandung des Reisemobils aus. Das Heckmodul 18 weist eine rechteckige Grundform auf.

Das Heckmodul 18 weit ein flächiges Sandwichelement 20 auf. Das flächige Sandwichelement 20 bildet einen Großteil des Heckmoduls 18 aus. Das flächige Sandwichelement 20 bildet mehr als 50% des Heckmoduls 18 aus. Das flächige Sandwichelement 20 erstreckt sich über mehr als 50% einer Fläche des Heckmoduls 18. Vorzugsweise bildet das flächige Sandwichelement 20 mehr als 75% des Heckmoduls 18 aus. Das flächige Sandwichelement 20 bildet einen Hauptbereich des Heckmoduls 18 aus. Das Sandwichelement 20 bildet einen mittleren Bereich des Heckmoduls 18 aus. Das Sandwichelement 20 ist mittig zwischen den beiden Seitenwandmodulen 12, 14 angeordnet. Das Sandwichelement 20 weist im Wesentlichen eine Trapezform auf, wobei Seitenkanten des Sandwichelements 20 zumindest abschnittsweise gekrümmt ausgebildet sind. Die Seitenkanten des Sandwichelements 20 bilden gekrümmte Schenkel eines Trapezes aus. Die Seitenkanten des Sandwichelements 20 sind als ungleichmäßig gekrümmte Schenkel eines Trapezes ausgebildet. Eine Oberkante des Sandwischelements 20 bildet eine breite Grundseite des Trapezes aus. Das Sandwichelement 20 weist an seiner Oberkante eine Breite auf, die vorzugsweise zumindest 90% einer Breite des Heckmoduls 18 entspricht. Die Oberkante des Sandwichelements 20 ist dem Dachmodul 16 zugewandt. An seiner Oberkante ist das Sandwichelement 20 mit dem Dachmodul gekoppelt. Eine Unterkante des Sandwichelements 20 bildet eine schmale Grundseite des Trapezes aus. Das Sandwichelement 20 weist an seiner Unterkante eine Breite auf, die weniger als 75% einer Breite des Heckmoduls 18 entspricht. Die Unterseite des Sandwichelements 20 ist einer Bodenplatte der Reisemobilkarosserievorrichtung 10 zugewandt. Die Unterseite des Sandwichelements 20 ist einem Stoßstangenelement 22 der Reisemobilkarosserievorrichtung 10 zugewandt. Das Sandwichelement 20 ist zu seiner senkrecht zu der Unterkante bzw. Oberkante stehenden Mittelachse 24 spiegelsymmetrisch ausgebildet. Die Mittelachse 24 des Sandwichelements 20 ist in einem montierten Zustand koaxial zu einer Mittellängsachse der Reisemobilkarosserievorrichtung 10, insbesondere des Reisemobils ausgerichtet. Die im Vorhergehenden beschriebene Form des Sandwichelements 20 ist dabei beispielhaft zu verstehen. Grundsätzlich ist es auch denkbar, dass das Sandwichelement 20 eine andere Form, insbesondere eine andere Grundform aufweist. Grundsätzlich wäre es denkbar, dass das Sandwichelement beispielsweise rechteckig oder in Form eines Trapezes mit geraden Seitenkanten ausgebildet ist. Die Form des Sandwichelements 20 ist vorzugsweise insbesondere in Abhängigkeit eines gewünschten Designs des Heckmoduls 18 gewählt.

Das Sandwichelement 20 ist als ein Plattenelement ausgebildet. Das Sandwichelement 20 ist als ein in Sandwichbauweise hergestelltes Plattenelement ausgebildet. Das Sandwichelement 20 weist zwei voneinander beabstandet angeordnete Deckschichten und einen dazwischen angeordneten Kern auf. Das Sandwichelement 20 weist eine Außenschicht 26 auf. Die Außenschicht 26 ist von einem plattenartigen Element gebildet. Vorzugsweise ist die Außenschicht 26 als eine ebene Platte ausgebildet. Die Außenschicht 26 ist vorzugsweise von einem Kunststoff gebildet. Grundsätzlich ist es auch denkbar, dass die Außenschicht 26 von einer Metallplatte gebildet ist, beispielsweise einem Aluminiumblech. Die Außenschicht 26 bildet in einem montierten Zustand die Außenseite des Sandwichelements 20 aus. Das Sandwichelement 20 weist eine Innenschicht 28 auf. Die Innenschicht 28 ist von einem plattenartigen Element gebildet. Vorzugsweise ist die Innenschicht 28 als eine ebene Platte ausgebildet. Die Innenschicht 28 ist vorzugsweise von einem Kunststoff gebildet. Die Innenschicht 28 ist beabstandet zu der Außenschicht angeordnet. Die Innenschicht 28 und die Außenschicht 26 schließen einen Innenraum ein. Das Sandwichelement 20 weist ein Kernelement 30 auf. Das Kernelement 30 ist zwischen der Innenschicht 28 und der Außenschicht 26 angeordnet. Das Kernelement 30 füllt den Innenraum zwischen der Innenschicht 28 und der Außenschicht 26 aus. Das Kernelement 30 ist mit der Außenschicht 26 und der Innenschicht 28 verbunden. Das Kernelement 30 ist vorzugsweise mittels einer Klebeverbindung fest mit der Außenschicht 26 und der Innenschicht 28 verbunden. Das Kernelement 30 ist als ein Schaumkern ausgebildet. Das Kernelement 30 ist vorzugsweise von einem PU Schaum gebildet. Grundsätzlich ist es auch denkbar, dass das Kernelement 30 von einem Wabenkern aus einem geeigneten Werkstoff gebildet ist. Durch das große Sandwichelement 20, das einen Großteil des Heckmoduls 18 ausmacht, kann ein besonders leichtes Heckmodul 18 bereitgestellt werden. Insbesondere in einem mittleren Bereich, in dem das Heckmodul 18 im Wesentlichen Flach ausgebildet ist, wird das leichte Sandwichelement 20 verwendet.

Das Heckmodul 18 weist zwei Seitenelemente 32, 34 auf. Die Seitenelemente 32, 34 bilden zusammen mit dem Sandwichelement 20 eine Grundstruktur des Heckmoduls 18 aus. Die Seitenelemente 32, 34 sind jeweils seitlich des Sandwichelements 20 angeordnet. Die Seitenelemente 32, 34 bilden eine tragende Aufnahme für das Sandwichelement 20 aus. Das Sandwichelement 20 ist mit den beiden Seitenelementen 32, 34 verbunden. Über die Seitenelemente 32, 34 ist das Sandwichelement 20 fest mit dem Rest des Karosserieaufbaus verbunden. Über die Seitenelemente 32, 34 ist das Sandwichelement 20 mit den Seitenwandmodulen 12, 14 verbunden. Das Sandwichelement 20 ist zwischen den Seitenelementen 32, 34 angeordnet. Die Seitenelemente 32, 34 bilden zusammen mit dem zwischen den Seitenelementen 32, 34 angeordneten Sandwichelement 20 eine geschlossene Grundstruktur des Heckmoduls 18 aus.

Die Seitenelemente 32, 34 bilden Seitebereiche des Heckmoduls 18 aus. Die Seitenelemente 32, 34 weisen jeweils eine im Wesentlichen gerade Außenkante 36, 38 auf. Die Außenkanten 36, 38 schließen das Heckmodul 18 seitlich ab. Die Außenkanten 36 38 verlaufen parallel zueinander. Die Außenkanten 36, 38 der Seitenelemente 32, 34 bilden eine seitliche Wandung des Heckmoduls 18 aus. Die Außenkanten 36, 38 bilden einen Teil der Seitenwand des Reisemobils aus. Die Außenkanten 36, 38 der Seitenelemente 32, 34 verlaufen vorzugsweise parallel zu den Seitenwandmodulen 12, 14. Die Seitenelemente 32, 34 sind zur Anbindung des Heckmoduls 18 an die Seitenwandmodule 12, 14 vorgesehen. Die Seitenelemente 32, 34 sind zur festen Verbindung mit den Seitenwandmodulen 12, 14 vorgesehen. In einem montierten Zustand sind die Seitenelemente 32, 34 starr mit dem jeweiligen Seitenwandmodul 12, 14 verbunden.

Die Seitenelemente 32, 34 bilden eine tragende Struktur des Heckmoduls 18 aus. Die Seitenelemente 32, 34 bilden Montage- und Verbindungselemente des Heckmoduls 18 aus. Die Seitenelemente 32, 34 sind als Montage- und Verbindungselemente ausgebildet, die dazu vorgesehen sind jeweils direkt mit dem zugeordneten Seitenwandmodul 12, 14 verbunden zu werden. Die Seitenelemente 32, 34 bilden eine Montagestruktur des Heckmoduls 18 aus, an dem weitere Bauteile des Heckmoduls 18 fest an das Heckmodul 18 angebunden werden können. Vorzugsweise sind weitere Bauteile an die von den Seitenelementen 32, 34 ausgebildete Montagestruktur form- und oder kraftschlüssig an das Heckmodul 18 angebunden. Vorzugsweise sind weitere Bauteile des Heckmoduls 18 mittels Schraubenverbindungen fest an den Seitenelementen 32, 34, welche die Montagestruktur des Heckmoduls 18 ausbilden, angebunden.

Die Seitenelemente 32, 34 sind im Wesentlichen gleich ausgebildet. Die Seitenelemente 32, 34 sind spiegelsymmetrisch zueinander ausgebildet. Da die Seitenelemente 32, 34 im Wesentlichen gleich aufgebaut sind, soll im Folgenden lediglich das eine Seitenelement 32 im Detail beschrieben werden. Die folgende Beschreibung eines Aufbaus des einen Seitenelements 32 kann auch zur Erläuterung des zweiten Seitenelements herangezogen werden.

Das Seitenelement 32 weist einen Hartschaum-Grundkörper 40 auf. Der Hartschaum-Grundkörper 40 bildet einen tragenden Grundkörper des Seitenelements 32 aus. Der Hartschaum-Grundkörper 40 bildet in Teilbereichen eine Kontur einer Rückseite des Seitenelements 32 aus. Der Hartschaum-Grundkörper 40 bildet vorzugsweise in einem Großteil eine Außenkontur des Seitenelements 32 aus. Der Hartschaum-Grundkörper 40 ist von einem geschäumten Hartschaum ausgebildet. Der Hartschaum-Grundkörper 40 ist aus einem EPP gebildet. Der Hartschaum-Grundkörper 40 ist als ein EPP-Grundkörper gebildet. Der Hartschaum-Grundkörper 40 ist aus einem Expandierten Polypropylen gebildet. Grundsätzlich wäre es auch denkbar, dass der Hartschaum-Grundkörper 40 aus einem anderen Hartschaum gebildet ist. Beispielsweise wäre dabei denkbar, dass der Hartschaum-Grundkörper 40 des Seitenelements 32 aus einem XPS-Schaum (extrudierter Polystyrol-Hartschaum), oder einem EPS (expandierter Polystyrol-Hartschaum ausgebildet ist. Beispielsweise ist es denkbar, dass der der Hartschaumgrundkörper aus einem EPP gebildet ist.

Das Seitenelement 32 weist ein flächiges Kunststoffelement 42 auf. Das flächige Kunststoffelement 42 bildet eine Außenwandung des Seitenelements 32 aus. Das Kunststoffelement 42 ist als ein Tiefziehbauteil ausgebildet. Das Kunststoffelement 42 ist aus einem tiefgezogenen Kunststoff ausgebildet. Vorzugsweise ist das Kunststoffelement 42 aus einem Thermoplast ausgebildet. Grundsätzlich wäre es auch denkbar, dass der Seitenelement aus einem GFK-Element ausgebildet ist. Das flächige Kunststoffelement 42 bildet insbesondere eine Außenwandung des Seitenelements 32 aus. Das Kunststoffelement 42 schließt das Seitenelement 32 nach außen hin ab. Das Kunststoffelement 42 bildet im Bereich des Seitenelements 32 eine Außenfläche des Heckmoduls 18 aus. Das Kunststoffelement 42 ist auf einer Außenseite des Hartschaumgrundkörpers 40 angeordnet. Das flächige Kunststoffelement 42 ist vorzugsweise lediglich auf einer Außenseite des Hartschaum-Grundkörpers 40 angeordnet. Vorzugsweise bildet das flächige Kunststoffelement 42 lediglich eine Außenseite des Seitenelements 32 aus. Das flächige Kunststoffelement 42 bildet eine Außenkontur des Seitenelements 32 aus. Das Kunststoffelement 42 weist in einem unteren Bereich eine Montagevertiefung 44 auf. Die Montagevertiefung 44 ist zu einer Montage eines Rücklichtmoduls 46 vorgesehen. Das Rücklichtmodul 46 ist als ein Lichtmodul ausgebildet, das mehrere Lichtelemente, wie beispielsweise ein Rücklicht, einen Blinker, ein Rückfahrtlicht, oder andere Lichtelemente des Reisemobils aufweist. Das Rücklichtmodul 46 weist vorzugsweise einen Montagegrundkörper auf. Über den Montagegrundkörper ist das Rücklichtmodul 46 an dem Seitenelement 32 anbindbar. Das Rücklichtmodul 46 ist an den Hartschaum-Grundkörper 40 des Seitenelements 32 befestigt. Der Hartschaum-Grundkörper 40 weist in dem Bereich der Montagevertiefung 44 einen Montagebereich auf, an dem das Rücklichtmodul 46 mit seinem Montagegrundkörper befestigt ist. Der Montagebereich ist vorzugsweise lediglich von dem Hartschaum-Grundkörper 40 ausgebildet. Grundsätzlich ist es denkbar, dass der Hartschaum-Grundkörper 40 ein zusätzliches Montageelement aufweist, an das das Rücklichtmodul 46 mit seinem Montagegrundkörper montiert ist. Das zusätzliche Montageelement kann dabei beispielsweise als ein in den Hartschaum-Grundkörper 40 eingebrachter Einleger oder als ein auf den Hartschaum-Grundköper 40 aufgeklebtes Element, wie beispielsweise eine Montageplatte ausgebildet sein.

Das Kunststoffelement 42 ist fest mit dem Hartschaum-Grundkörper 40 verbunden. Vorzugsweise ist das Kunststoffelement 42 untrennbar mit dem Hartschaum-Grundköper 40 verbunden. Das Kunststoffelement 42 bildet zusammen mit dem Hartschaum-Grundkörper 40 eine Einheit. Das Kunststoffelement 42 ist dazu vorgesehen, formschlüssig oder stoffschlüssig an dem Hartschaum-Grundkörper 40 befestigt zu werden. Das flächige Kunststoffelement 42 ist mit dem Hartschaum-Grundkörper 40 verklebt. Grundsätzlich ist es auch denkbar, dass das Kunststoffelement 42 auf eine andere Weise stoffschlüssig, formschlüssig oder kraftschlüssig mit dem Hartschaum-Grundkörper 40 verbunden ist. Beispielsweise ist auch denkbar, dass das flächige Kunststoffelement 42 in Teilbereichen mit dem Hartschaum-Grundkörper 40 verschraubt ist. Das Kunststoffelement 42 liegt vorzugsweise über einen Großteil mit seiner Innenseite an dem Hartschaum-Grundkörper 40 an. Dadurch kann das Seitenelement 32 besonders stabil ausgebildet werden.

Der Hartschaum-Grundkörper 40 weist auf seiner Rückseite mehrere Befestigungskanäle 48 auf. Die Befestigungskanäle 48 sind als Vertiefungen, insbesondere als Nuten in dem Hartschaum-Grundkörper 40 ausgebildet. Die Befestigungskanäle 48 sind dazu vorgesehen, dass ein Klebeelement 50, beispielsweise in Form einer Kleberaupe oder eines Klebestreifens, zur Verbindung des Kunststoffelements 42 mit dem Hartschaum-Grundkörper 40 darin angeordnet ist. In den Befestigungskanälen 48 sind jeweils Klebeelemente 50 angeordnet, die in den Befestigungskanälen 48 verklebt sind und an denen das flächige Kunststoffelement 42 klebt. Grundsätzlich wäre es auch denkbar, dass der Hartschaum-Grundkörper 40 lediglich einen Befestigungskanal 48 aufweist, der umlaufend ausgebildet ist.

Die Seitenelemente 32, 34 sind als Montage- und Verbindungselemente ausgebildet. Die Seitenelemente 32, 34 sind dazu vorgesehen, mit ihrem Hartschaum-Grundkörper 40 jeweils direkt mit dem zugeordneten Seitenwandmodul 12, 14 verbunden zu werden. Die Seitenelemente 32, 34 sind über Schraubenverbindungen, die in den Hartschaum-Grundkörper 40 eingeschraubt sind, jeweils mit dem zugeordneten Seitenwandmodul 12, 14 verbunden. Grundsätzlich ist es auch denkbar, dass die Seitenelemente alternativ oder zusätzlich über Steck- und/oder Klebeverbindungen fest mit dem jeweiligen Seitenwandmodul 12, 14 verbunden sind. Ferner sind weitere Elemente an die Seitenelemente 32, 34 angebunden. Das Stoßstangenelement 22 des Heckmoduls 18 ist an den Seitenelementen 32, 34 montiert. Das Stoßstangenelement 22 ist mit seinen Seitenbereichen jeweils an dem entsprechenden Seitenelemente 32, 34 montiert. Das Stoßstangenelement 22 ist lediglich an den Seitenelementen 32, 34 montiert.

Der Hartschaum-Grundkörper 40 des jeweiligen Seitenelements 32, 34 und das Sandwichelement 40 sind zumindest teilweise überlappend ausgebildet. Die Hartschaum-Grundkörper 40 der Seitenelemente 32, 34 weisen jeweils einen Überlappungsbereich auf. In dem Überlappungsbereich ist der Hartschaum-Grundkörper 40 des jeweiligen Seitenelements 32, 34 über eine Klebeverbindung mit dem Sandwichelement 40 verbunden. Der Hartschaum-Grundkörper 40 des jeweiligen Seitenelements 32, 34 und das Sandwichelement 40 sind zusätzlich über den Überlappungsbereich formschlüssig miteinander verbunden. Dazu können die Überlappungsbereiche des Hartschaum-Grundkörpers 40 des jeweiligen Seitenelements 32, 34 formschlüssig in Hinterschnitten des Sandwichelements 20 eingreifen. Zudem sind die Hartschaum-Grundkörper 40 der jeweiligen Seitenelemente 32, 34 zusätzlich über mehrere Schraubenverbindungen miteinander verbunden.

Das Kunststoffelement 42 ist in montiertem Zustand dazu vorgesehen, sich bis in einen Bereich des Sandwichelements 20 zu erstrecken. Das Kunststoffelement 42 erstreckt sich auf einer Rückseite bis in einen Bereich des Sandwichelements 20. Das Kunststoffelement 42 des jeweiligen Seitenelements 32, 34 erstreckt sich bis in einen Bereich des Sandwichelements 20. Das Kunststoffelement 42 des jeweiligen Seitenelements 32, 34 überlappt einen Teilbereich des Sandwichelements 20. Dadurch überdeckt das Kunststoffelement 42 des jeweiligen Seitenelements 32, 34 einen Verbindungsbereich zwischen dem jeweiligen Seitenelement 32, 34 und dem Sandwichelement 20. Das Kunststoffelement 42 des jeweiligen Seitenelements 32, 34 überdeckt eine Verbindungsfuge zwischen dem Hartschaum-Grundkörper 40, also dem jeweiligen Seitenelement 32, 34 und dem Sandwichelement 20.

### Bezugszeichen

- 10: Reisemobilkarosserievorrichtung
- 12: Seitenwandmodul
- 14: Seitenwandmodul
- 16: Dachmodul
- 18: Heckmodul
- 20: Sandwichelement
- 22: Stoßstangenelement
- 24: Mittelachse
- 26: Außenschicht
- 28: Innenschicht
- 30: Kern
- 32: Seitenelement
- 34: Seitenelement
- 36: Außenkante
- 38: Außenkante
- 40: Hartschaum-Grundkörper
- 42: Kunststoffelement
- 44: Montagevertiefung
- 46: Rücklichtmodul
- 48: Befestigungskanal
- 50: Klebeelement

## Patentansprüche

1. Reisemobilkarosserievorrichtung, mit zumindest zwei Seitenwandmodulen (12, 14), einem Dachmodul (16) und einem Heckmodul (18), die zusammen zumindest einen Teil eines Karosserieaufbaus eines Reisemobils ausbilden, wobei das Heckmodul (18) eine rückwärtige Wandung des Karosserieaufbaus ausbildet, **dadurch gekennzeichnet, dass** das Heckmodul (18) zumindest ein flächiges Sandwichelement (20), das einen Großteil des Heckmoduls (18) ausbildet, und zumindest zwei Seitenelemente (32, 34) aufweist, die jeweils an einem der Seitenwandmodule (12, 14) angebunden sind und jeweils einen Seitenbereich des Heckmoduls (18) ausbilden.

2. Reisemobilkarosserievorrichtung nach Anspruch 1, **dadurch gekennzeichnet, dass** die Seitenelemente (32, 34) jeweils aus einem Hartschaum-Grundkörper (40) und einem mit dem Hartschaum-Grundkörper (40) verbundenen Kunststoffelement (42) gebildet sind.

3. Reisemobilkarosserievorrichtung nach Anspruch 1 oder 2, **dadurch gekennzeichnet, dass** die Seitenelemente (32, 34) als Montage- und Verbindungselemente ausgebildet sind, die dazu vorgesehen sind, mit ihrem Hartschaum -Grundkörper (40) jeweils direkt mit dem zugeordneten Seitenwandmodul (12, 14) verbunden zu werden.

4. Reisemobilkarosserievorrichtung nach einem der vorhergehenden Ansprüche, **dadurch gekennzeichnet, dass** das Heckmodul (18) ein Stoßstangenelement (22) aufweist, das lediglich an den Seitenelementen (32, 34) befestigt ist.

5. Reisemobilkarosserievorrichtung nach einem der vorhergehenden Ansprüche, **dadurch gekennzeichnet, dass** das Kunststoffelement (42) dazu vorgesehen ist, formschlüssig oder stoffschlüssig an dem Hartschaum-Grundkörper (40) befestigt zu werden

6. Reisemobilkarosserievorrichtung nach einem der vorhergehenden Ansprüche, **dadurch gekennzeichnet, dass** der Hartschaum-Grundkörper (40) auf seiner Rückseite zumindest einen Befestigungskanal (48) aufweist, wobei ein Klebeelement (50) zur Verbindung des Kunststoffelements (42) mit dem Hartschaum-Grundkörper (40) dazu vorgesehen ist, in dem Befestigungskanal (48) angeordnet zu werden.

7. Reisemobilkarosserievorrichtung nach einem der vorhergehenden Ansprüche, **dadurch gekennzeichnet, dass** der Hartschaum-Grundkörper (40) des jeweiligen Seitenelements (32, 34) und das Sandwichelement (20) zumindest teilweise überlappend ausgebildet sind.

8. Reisemobilkarosserievorrichtung nach einem der vorhergehenden Ansprüche, **dadurch gekennzeichnet, dass** der Hartschaum-Grundkörper (40) des jeweiligen Seitenelements (32, 34) und das Sandwichelement (20) formschlüssig und durch eine Klebeverbindung stoffschlüssig miteinander verbunden sind.

9. Reisemobilkarosserievorrichtung nach einem der vorhergehenden Ansprüche, **dadurch gekennzeichnet, dass** das Kunststoffelement (42) in montiertem Zustand dazu vorgesehen ist, sich bis in einen Bereich des Sandwichelements (20) zu erstrecken und eine Verbindungsfuge zwischen dem Hartschaum-Grundkörper (40) und dem Sandwichelement (20) zu überdecken.

10. Reisemobilkarosserievorrichtung nach einem der vorhergehenden Ansprüche, **dadurch gekennzeichnet, dass** der Hartschaum-Grundkörper (40) des Seitenelements (32, 34) und das Sandwichelement (20) dazu vorgesehen sind, über mehrere Schraubenverbindungen fest miteinander verbunden zu werden.
